# EUROPÄISCHE PATENTSCHRIFT

(11) **EP 0 621 601 B1**
(45) Veröffentlichungstag und Bekanntmachung des Hinweises auf die Patenterteilung: **02.06.1999**
(21) Anmeldenummer: 94105191.4
(22) Anmeldetag: 31.03.1994
(51) Int. Cl.: G11C 11/406, G06F 13/16

(54) **Prozessorschaltung mit Speichersauffrischung**
Processor circuit with memory refresh
Circuit de processeur avec rafraîchissement de mémoire

(30) Priorität: 20.04.1993 DE 4312866
(43) Veröffentlichungstag der Anmeldung: 26.10.1994
(73) Patentinhaber: SIEMENS AKTIENGESELLSCHAFT, 80333 München (DE)
(72) Erfinder: Freimuth, Franz, Dipl.-Ing., D-81827 München (DE); Kastl, Stefan, Dipl.-Ing. (FH), D-80686 München (DE)

(56) Entgegenhaltungen:
- EP-A- 0 058 795
- EP-A- 0 535 793

## Beschreibung

Die vorliegende Erfindung betrifft eine Prozessorschaltung mit einem Prozessor und Speicherbausteinen, wobei die Speicherbausteine zumindest teilweise als DRAMs ausgebildet sind, deren Speicherinhalt spätestens nach einer Speicherhaltezeit wieder aufgefrischt werden muß.

Eine derartige Prozessorschaltung ist beispielsweise in der Standard-PC-Architektur gemäß der Definition von IBM realisiert. Die Speicherhaltezeit, nach deren Ablauf spätestens ein sogenannter Refresh-Zyklus erfolgen muß, liegt definetionsgemäß bei 15 µs. Aufgrund der PC-Architektur kann dabei der Refresh-Zylus nur dann erfolgen, wenn der Schaltungsbus nicht belegt ist, sich also im Idle-Zustand befindet.

Aus der EP 0 058 795 ist eine Schaltung bekannt, mit der der Wartezustand eines Mikroprozessors mit peripherer Einheit abgebrochen wird, wenn ein Speicher-Refresh ansteht. Mit Abbruch des Wartezustands wird ein Interuptsignal erzeugt, das den Prozessor veranlaßt, per Software-Steuerung den abgebrochenen Zyklus zu wiederholen. Die periphere Einheit wird dadurch ein zweites Mal angesprochen, was bei bestimmten Peripheriegeräten, wie z.B. seriellen Schnittstellen, zu Datenverlusten führen könnte, da beim zweiten Zugriff bereits das nächste Datum abgeholt wird.

Die Standard-PC-Architektur ist besonders deswegen weit verbreitet, weil auf ihr Standardbetriebssysteme wie beispielsweise WINDOWS ablauffähig sind, so daß einem Anwender eine Vielzahl von Anwenderprogrammen zur Verfügung steht.

Die Notwendigkeit eines Refresh-Zyklus nach spätestens 15 µs stellt dabei schaltungsintern normalerweise kein Problem dar, da schaltungsinterne Zugriffe im Regelfall binnen weniger µs abgeschlossen sind.

Wenn dagegen die Ausführung mancher Befehle von äußeren Umständen abhängt, die dem Prozessor nicht bekannt sind und die auch durch den Prozessor nicht beeinflußbar sind, kann es geschehen, daß die Ausführungszeit des Befehls größer als die Speicherhaltezeit ist. In einem derartigen Fall können in den DRAMs Datenverluste auftreten. Dies muß unbedingt vermieden werden. Es stellt sich also die Aufgabe, auf möglichst einfache Art und Weise sicherzustellen, daß in den DRAMs keine Datenverluste auftreten.

Die Aufgabe wird mit einer Prozessorschaltung gemäß Anspruch 1 gelöst.

Das Aktivieren des Timers kann dabei auf unterschiedliche Art und Weise geschehen. Der Timer kann beispielsweise bei jedem Buszugriff aktiviert werden, unabhängig davon, ob der Buszugriff zeitkritisch ist oder nicht. Selbstverständlich kann das Aktivieren des Timers aber auch nur bei den zeitkritischen Zugriffen erfolgen. Das Verstreichen der Wartezeit wird dem Prozessor vorteilhaft dadurch gemeldet, daß der Timer an eine mit dem Prozessor verbundene Steuerleitung ein Steuersignal anlegt.

Das Problem nicht vorhersagbarer Befehlsausführungszeiten stellt sich insbesondere dann, wenn die Prozessorschaltung eine mit dem Schaltungsbus verbundene Schnittstelleneinheit aufweist, über die der Prozessor an einen Systembus anschließbar ist. In einem derartigen Fall muß der Timer bei jedem Buszugriff des Prozessors auf die Schnittstelleneinheit aktiviert werden.

Damit ein schaltungsinterner Abbruch des Busgewährungszugriffs nach außen verdeckt ist,
- weist die Schnittstelleneinheit Speicherelemente auf, deren Ausgangssignale über sperrbare Koppelelemente an den Systembus anlegbar sind,
- werden bei einem Zugriff des Prozessors auf die Schnittstelleneinheit der Zustand des Schaltungsbusses in die Speicherelemente eingeschrieben und die Koppelelemente durchgeschaltet und
- wird der Inhalt der Speicherelemente erst beim nächsten Zugriff des Prozessors auf die Schnittstelleneinheit überschrieben.

Weitere Vorteile und Einzelheiten ergeben sich aus der nachfolgenden Beschreibung eines Ausführungsbeispiels, anhand der Zeichnungen und in Verbindung mit den weiteren Unteransprüchen. Dabei zeigen:
- FIG 1: ein Blockschaltbild der Prozessorschaltung und
- FIG 2: ein Blockschaltbild eines elektronischen Systems.

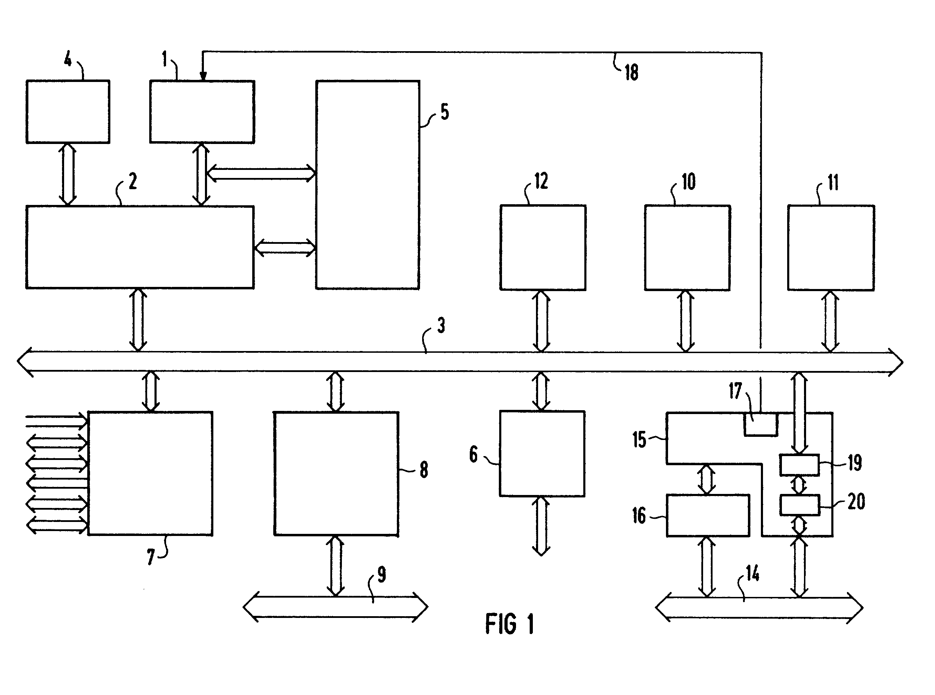

Gemäß FIG 1 weist die Prozessorschaltung einen Prozessor 1 auf, der über den Prozessorcontroller 2 mit dem Schaltungsbus 3 verbunden ist. An den Prozessorcontroller 2 ist ein als Remanentspeicher (ROM) ausgebildeter Speicher 4 und ein als DRAM ausgebildeter Speicher 5 angeschlossen. Der Speicher 5 ist auch direkt mit dem Prozessor 1 verbunden. Im Speicher 4 ist das sogenannte BIOS abgespeichert, der Speicher 5 dient als Arbeitsspeicher. Der Speicher 5 hat eine Speicherhaltezeit von etwas über 15 µs. Spätestens nach 15 µs muß also eine Auffrischung des Inhalts des Speichers 5 erfolgen, um Datenverluste zu vermeiden.

Der Prozessor 1 ist beispielsweise ein INTEL 80486 und der Prozessorcontroller 2 ein Standard-PC/AT-Controller. Die Prozessorschaltung weist folglich eine Standard-PC-Architektur auf. Bei dieser Architektur wird der Refresh des Speichers 5 vom Prozessorcontroller 2 ausgeführt. Der Refresh kann dabei nur dann erfolgen, wenn der Prozessorcontroller 2 nicht auf den Schaltungsbus 3 zugreift.

Zur Kommunikation mit dem Anwender sind an den Schaltungsbus 3 noch eine Monitorschnittstelle 6, z. B. eine VGA-Karte, und eine bidirektionaler Schnittstelleneinheit 7 angeschlossen. Über die Schnittstelleneinheit 7 sind beispielsweise folgende der Übersichtlichkeit halber nicht dargestellte Einheiten an den Schaltungsbus 3 angeschlossen: Eine Tastatur, ein Drucker, ein Diskettenlaufwerk und ein Massenspeicher (Festplatte oder CD-ROM). Ferner weist die Schnittstelleneinheit 7 zwei serielle Schnittstellen auf.

Die in FIG 1 dargestellte Prozessorschaltung dient der Steuerung eines technischen Prozesses. Folglich weist die Prozessorschaltung auch eine Schnittstelleneinheit 8 auf, an den ein schaltungsbezogener externer Bus 9, z.B. ein SMP-Bus anschließbar ist. An den Bus 9 sind Peripheriebaugruppen, z. B. Eingabebaugruppen oder Ausgabebaugruppen, anschließbar. Diese Baugruppen sind in FIG 1 der Übersichtlichkeit halber jedoch nicht dargestellt.

Auf den schaltungsbezogenen Bus 9 kann nur der Prozessor 1 bzw. der Prozessorcontroller 2 zugreifen. Von daher ist das Reaktionsverhalten der an den baugruppenbezogenen Bus 9 angeschlossenen Baugruppen bekannt. Bei geeigneter Realisierung ist folglich gewährleistet, daß jeder Zugriff auf den schaltungsbezogenen Bus 9 binnen 15 µs abgeschlossen ist.

Um die Steuerungstauglichkeit der in FIG 1 dargestellten Prozessorschaltung weiter zu erhöhen, weist die Prozessorschaltung zusätzlich zum normalen Interruptcontroller, den jede Prozessorschaltung aufweist, einen weiteren Interrupt-controller 10 auf. Mittels dieses Interruptcontrollers 10 stehen maximal 64 Interrupteingänge zur Verfügung. Die Prozessorschaltung wird dadurch alarmfähig. Zum remanenten Abspeichern wichtiger Daten weist die Prozessorschaltung ferner einen elektrisch schreibbaren Remanentspeicher 11, z. B. ein EEPROM, auf. Schließlich steht auch noch ein Timerbaustein 12 zur Verfügung.

Die in FIG 1 beschriebene Prozessorschaltung ist in der Regel als Baugruppe 13 eines modular aufgebauten Systems ausgebildet. Mehrere Baugruppen sind dabei über den Systembus 14 miteinander verbunden. Um auf den Systembus 14 zugreifen zu können, weist die Prozessorschaltung gemäß FIG 1 daher eine Schnittstelleneinheit 15 und ein dual ported RAM 16 auf.

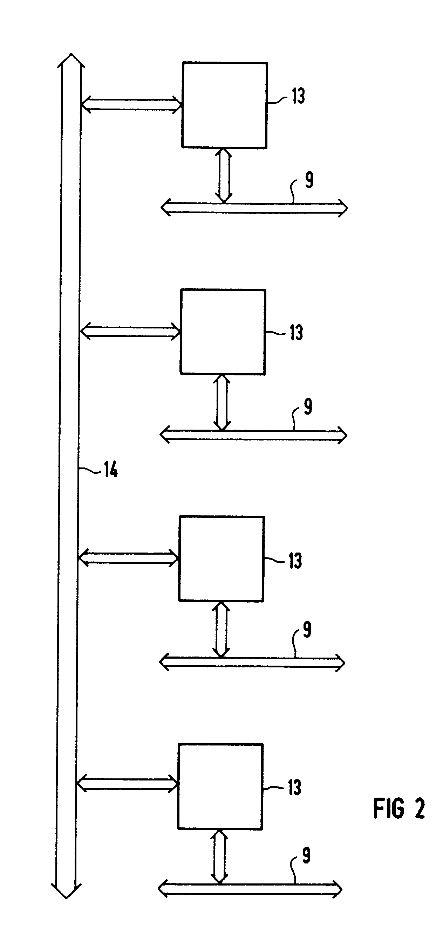

Wie in FIG 2 dargestellt, weist ein elektrisches System in der Regel mehrere Baugruppen 13 mit Prozessorschaltungen gemaß FIG 1 auf. Jede Baugruppe 13 mit einer Prozessorschaltung gemaß FIG 1 kann dabei als Busmaster auf den Systembus 14 zugreifen. Der Systembus 14 ist also ein multimasterfähiger Bus.

Der Zugriff auf den Systembus 14 kann den Systembus 14 für eine Zeit blockieren, die erheblich länger als die zulässige Wartezeit von 15 µs ist. Wenn daher eine andere Baugruppe 13, die ebenfalls eine Prozessorschaltung gemaß FIG 1 aufweist und momentan nicht auf den Systembus 14 zugreift, auf den Systembus 14 zugreifen will, so kann sie das nicht tun. Der versuchte Buszugriff wird dabei durch diese Baugruppe 13 erst nach einer systembusspezifischen Wartezeit abgebrochen, die erheblich langer als die Speicherhaltezeit von 15 µs ist. Beim sogenannten AMS-Bus beträgt diese Wartezeit 10 ms, beim VME-Bus 6 ms.

Um daher bei einem erfolglosen Zugriff auf den Systembus 14 Datenverluste im Speicher 5 zu vermeiden, weist die Schnittstelleneinheit 15 einen Timer 17 auf, der bei jedem Zugriff des Prozessors 1 auf die Schnittstelleneinheit 15 aktiviert wird. Wenn der Zugriff auf den Systembus 14 gelingt und binnen 15 µs abgeschlossen ist, wird der Timer 17 wieder deaktiviert. Wenn dagegen der Zugriff auf den Systembus 14 nach 15 µs noch nicht abgeschlossen ist, meldet dies der Timer 17 über die Steuerleitung 18 an den Prozessor 1. Wenn der Prozessor 1 z. B. als INTEL 80486 ausgebildet ist, ist die Steuerleitung 18 prozessorseitig mit dem sogenannten Backoff-Pin verbunden. Durch das an die Steuerleitung 18 angelegte Signal wird der Zugriff des Prozessors 1 auf den Schaltungsbus 3 abgebrochen. Dadurch erkennt der Timer 17, daß eine Auffrischung des Inhalts des Speichers 5 erfolgt. Er nimmt daraufhin das Steuersignal zurück und deaktiviert sich.

Aufgrund des Abbruchs des Zugriffs auf den Schaltungsbus 3 kann nunmehr (rechtzeitig!) ein Refresh-Zyklus erfolgen, so daß im Speicher 5 keine Datenverluste entstehen. Nach dem Wiederauffrischen der im Speicher 5 abgespeicherten Daten wird erneut versucht, auf den Systembus 14 zuzugreifen. Der abgebrochene Buszugriff wird also wiederholt.

Während des Wiederauffrischens der Daten kann der Prozessor 1 nicht auf den Schaltungsbus 3 zugreifen. Damit kann der Prozessor 1 insbesondere auch nicht auf die Schnittstelleneinheit 15 und den Systembus 14 zugreifen. Um zu verhindern, daß in der Zeit, in der das Wiederauffrischen der Daten erfolgt, die momentane Belegung des Systembusses 14 beendet wird und kurz danach, noch innerhalb des Auffrischens, eine andere Baugruppe 13 den Systembus 14 erneut belegt, erfolgt der Abbruch des Buszugriffs vom Systembus 14 verdeckt, d.h. der Systembus 14 bemerkt nichts vom Abbruch des versuchten Buszugriffs. Der verdeckte Abbruch wird wie folgt realisiert:

Die Schnittstelleneinheit 15 weist Speicherelemente 19 auf. Beim Zugriff des Prozessors 1 auf die Schnittstelleneinheit 15 wird der Zustand des Schaltungsbusses 3 in die Speicherelemente 19 eingeschrieben. Die Ausgangssignale der Speicherelemente 19 werden dann über die Tristate-Treiber 20, die als sperrbare Koppelelemente wirken, an den Systembus 14 angelegt. Die Speicherelemente 19 sind sogenannte Latches. Dadurch bleiben die Ausgangssignale der Speicherelemente 19 erhalten, auch wenn der Zugriff des Prozessors 1 über den Schaltungsbus 3 auf die Speicherelemente 19 beendet ist. Der Inhalt der Speicherelemente 19 wird erst beim nächsten Zugriff des Prozessors 1 auf die Schnittstelleneinheit 15 überschrieben. Die Koppelelemente 20 werden wieder gesperrt, wenn entweder der Zugriff auf den Systembus 14 abgeschlossen worden ist oder die Wartezeit von z. B. 10 ms abgelaufen ist.

Mit der obenstehend beschriebenen Prozessorschaltung ist es möglich, die PC-Architektur unverändert an multimasterfähige Busse (Systembus 14) anzukoppeln. Dadurch ist es möglich, die weitverbreitete PC-Architektur in der Steuerungswelt einzusetzen. Wenn die Prozessorschaltung leistungsfähig genug ist, ist es sogar möglich, gleichzeitig ein Steuerungsprogramm und PC-typische Visualisierungssoftware ablaufen zu lassen.

In der Praxis wird obenstehend beschriebene Prozessorschaltung auf Leiterplatten im Doppeleuropaformat realisiert. Der baugruppenbezogene Bus 9 belegt dabei die untere Steckerleiste, der Systembus 14 die obere.

Die Prozessorschaltung ist vorteilhaft in Steuerungssystemen mit verteilter Intelligenz verwendbar. Es könnte beispielsweise eine Werkzeugmaschinensteuerung oder Robotersteuerung realisiert werden, bei der je anzusteuernder Achse eine Baugruppe 13 vorhanden ist und eine zusätzliche Baugruppe 13 die Rolle des Supervisors übernimmt.

## Patentansprüche

1. Prozessorschaltung mit einem Prozessor (1) und Speicherbausteinen (4,5),
- wobei die Speicherbausteine (4,5) zumindest teilweise als DRAMs (5) ausgebildet sind, deren Speicherinhalt spätestens nach einer Speicherhaltezeit wieder aufgefrischt werden muß,
- wobei die Prozessorschaltung eine mit dem Schaltungsbus (3) verbundene Schnittstelleneinheit (15) aufweist,
- wobei die Schaltung einen Timer (17) aufweist, der vom Prozessor (1) bei zumindest einem Teil der Zugriffe des Prozessors (1) auf den Schaltungsbus (3) aktiviert wird,
- wobei der Timer (17) dem Prozessor (1) das Verstreichen einer Wartezeit, die kleiner oder gleich der Speicherhaltezeit ist, meldet, wenn der Buszugriff nach Ablauf der Wartezeit noch nicht abgeschlossen ist,
- wobei in diesem Fall der Prozessor (1) den Buszugriff abbrechen und eine Auffrischung des Speicherinhalts der DRAMs (5) erfolgen kann,
**dadurch gekennzeichnet,**
- daß die Auffrischung des Speicherinhalts nur erfolgen kann, wenn der Prozessor (1) nicht auf einen Schaltungsbus (3) zugreift,
- daß die Schnittstelleneinheit (15) Speicherelemente (19) aufweist, deren Ausgangssignale über sperrbare Koppelelemente (20) an einen Systembus (14) anlegbar sind,
- daß bei einem Zugriff des Prozessors (1) auf die Schnittstelleneinheit (15) der Zustand des Schaltungsbusses (3) in die Speicherelemente (19) eingeschrieben wird und die Koppelelemente (20) durchgeschaltet werden, und
- daß der Inhalt der Speicherelemente (19) erst beim nächsten Zugriff des Prozessors (1) auf die Schnittstelleneinheit (15) überschrieben wird.

2. Prozessorschaltung nach Anspruch 1, **dadurch gekennzeichnet,** daß das Verstreichen der Wartezeit dem Prozessor (1) dadurch gemeldet wird, daß der Timer (17) an eine mit dem Prozessor (1) verbundene Steuerleitung (18) ein Steuersignal anlegt.

3. Prozessorschaltung nach Anspruch 2, **dadurch gekennzeichnet,** daß der Timer (17) beim Erkennen einer Auffrischung das Steuersignal zurücknimmt und sich deaktiviert.

4. Prozessorschaltung nach Anspruch 1, 2 oder 3, **dadurch gekennzeichnet,** daß der Prozessor (1) nach der Auffrischung des Speicherinhalts der DRAMs (5) den abgebrochenen Buszugriff wiederholt.

5. Prozessorschaltung nach einem der obigen Ansprüche, **dadurch gekennzeichnet,** daß die Prozessorschaltung eine Standard-PC-Architektur aufweist.

6. Prozessorschaltung nach Anspruch 1, **dadurch gekennzeichnet,** daß der Timer (17) in die Schnittstelleneinheit (15) integriert ist.

7. Prozessorschaltung nach Anspruch 1 oder 6, **dadurch gekennzeichnet,** daß der Systembus (14) als multimasterfähiger Bus, z. B. als AMS- oder als VME-Bus, ausgebildet ist.

8. Industrieautomatisierungssystem mit einer Prozessorschaltung nach einem der Ansprüche 1 bis 7.

## Claims

1. Processor circuit arrangement having a processor (1) and memory modules (4, 5),
- wherein the memory modules (4, 5) are designed at least in part as DRAM's (5), the memory contents of which must be refreshed at the latest after a memory holding time,
- wherein the processor circuit arrangement has an interface unit (15) connected to the circuit bus (3),
- wherein the circuit arrangement has a timer (17) which is activated by the processor (1) for at least a portion of the instances of access of the processor (1) to the circuit bus (3),
- wherein the timer (17) signals to the processor (1) that a waiting time which is shorter than or equal to the memory holding time has expired if the bus access has not yet terminated at the end of the waiting time,
- wherein in this case the processor (1) can abort the bus access and the memory contents of the DRAM's (5) can be refreshed,
characterised
- in that the memory contents can only be refreshed if the processor (1) is not accessing a circuit bus (3),
- in that the interface unit (15) has memory elements (19), the output signals of which can be applied to a system bus (14) by way of blockable coupling elements (20),
- in that when the processor (1) accesses the interface unit (15) the state of the circuit bus (3) is written into the memory elements (19) and the coupling elements (20) are connected through, and
- in that the contents of the memory elements (19) are only overwritten the next time the processor (1) accesses the interface unit (15).

2. Processor circuit arrangement according to claim 1, characterised in that the fact that the waiting time has expired is signalled to the processor (1) in that the timer (17) applies a control signal to a control line (18) which is connected to the processor (1).

3. Processor circuit arrangement according to claim 2, characterised in that when a refresh mode is identified the timer (17) cancels the control signal and is deactivated.

4. Processor circuit arrangement according to claim 1, 2 or 3, characterised in that the processor (1) repeats the aborted bus access after the memory contents of the DRAM's (5) have been refreshed.

5. Processor circuit arrangement according to one of the above claims, characterised in that the processor circuit arrangement has standard PC architecture.

6. Processor circuit arrangement according to claim 1, characterised in that the timer (17) is integrated in the interface unit (15).

7. Processor circuit arrangement according to claim 1 to 6, characterised in that the system bus (14) is designed as a bus with multi-master capability, for example as an AMS bus or as a VME bus.

8. Industrial automation system having a processor circuit arrangement according to one of claims 1 to 7.

## Revendications

1. Circuit de processeur comportant un processeur (1) et des composants formant mémoires (4, 5), dans lequel
- les composants formant mémoires (4, 5) sont conçus au moins en partie comme des DRAM (5) dont le contenu doit être rafraîchi au plus tard après un temps de maintien en mémoire,
- le circuit de processeur comporte une unité d'interface (15) reliée au bus de circuit (3),
- le circuit comporte un temporisateur (17) qui est activé par le processeur (1) pour au moins une partie des accès du processeur (1) au bus de circuit (3),
- le temporisateur (17) signale au processeur (1) l'écoulement d'un temps d'attente, qui est inférieur ou égal au temps de maintien en mémoire, si l'accès au bus n'est pas encore terminé après l'écoulement du temps d'attente,
- dans ce cas, le processeur (1) interrompt l'accès au bus et un rafraîchissement du contenu de la mémoire DRAM (5) peut s'effectuer,
caractérisé par le fait que
- le rafraîchissement du contenu de la mémoire ne peut s'effectuer que lorsque le processeur (1) n'accède pas à un bus de circuit (3),
- l'unité d'interface (15) comporte des éléments de mémorisation (19) dont les signaux de sortie peuvent être appliqués à un bus de système (14) par l'intermédiaire d'éléments de connexion (20) pouvant être bloqués,
- lors d'un accès du processeur (1) à l'unité d'interface (15), l'état du bus de circuit (3) est enregistré dans les éléments de mémorisation (19) et les éléments de connexion (20) sont connectés, et
- le contenu des éléments de mémorisation (19) n'est recouvert que lors du prochain accès du processeur (1) à l'unité d'interface (15).

2. Circuit de processeur selon la revendication 1, caractérisé par le fait que l'écoulement du temps d'attente est signalé au processeur (1) par le fait que le temporisateur (17) applique un signal de commande à une ligne de commande (18) reliée au processeur (1).

3. Circuit de processeur selon la revendication 2, caractérisé par le fait que, lorsqu'il reconnaît un rafraîchissement, le temporisateur (17) retire le signal de commande et se désactive.

4. Circuit de processeur selon la revendication 1, 2 ou 3, caractérisé par le fait que, après le rafraîchissement du contenu de la mémoire DRAM (5), le processeur (1) répète l'accès au bus qui a été interrompu.

5. Circuit de processeur selon l'une des revendications précédentes, caractérisé par le fait que le circuit de processeur a une architecture PC standard.

6. Circuit de processeur selon la revendication 1, caractérisé par le fait que le temporisateur (17) est intégré dans l'unité d'interface (15).

7. Circuit de processeur selon la revendication 1 ou 6, caractérisé par le fait que le bus de système (14) est conçu comme un bus capable d'avoir plusieurs maîtres, par exemple comme un bus AMS ou comme un bus VME.

8. Système d'automatisation industrielle comportant un circuit de processeur selon l'une des revendications 1 à 7.
